# EUROPEAN PATENT APPLICATION

(11) **EP 4 175 061 A1**
(43) Date of publication of application: **03.05.2023**
(21) Application number: 22204360.6
(22) Date of filing: 28.10.2022
(51) Int. Cl.: H01P 1/387

(54) **NON-RECIPROCAL CIRCUIT ELEMENT AND COMMUNICATION APPARATUS HAVING THE SAME**

(30) Priority: 29.10.2021 CN 202111271027
(71) Applicant: TDK Corporation, Tokyo 103-6128 (JP); TDK Dalian Corporation, Liaoning 116600 (CN)
(72) Inventor: OHATA, Hidenori, Tokyo, 103-6128 (JP); SATO, Kosuke, Tokyo, 103-6128 (JP); SASAKI, Hideyuki, Tokyo, 103-6128 (JP)
(74) Representative: Epping - Hermann - Fischer

(57) **Abstract**

Disclosed herein is a non-reciprocal circuit element that includes a dielectric substrate having upper and lower surfaces, a magnetic rotator mounted on the dielectric substrate, and a permanent magnet that applies a magnetic field to the magnetic rotator. The dielectric substrate has a connection pattern formed on the upper surface thereof and connected to the magnetic rotator, a terminal electrode formed on the lower surface thereof and connected to the connection pattern, and a capacitor pattern formed on the upper surface, lower surface or inside the dielectric substrate.

## Description

### BACKGROUND OF THE ART

### --Field of the Art

The present disclosure relates to a non-reciprocal circuit element and a communication apparatus having the same and, more particularly, to a surface mount type non-reciprocal circuit element having a structure in which a magnetic rotator is mounted on a dielectric substrate and a communication apparatus having such a non-reciprocal circuit element.

### --Description of Related Art

A non-reciprocal circuit element such as an isolator or a circulator, which is a kind of a magnetic device, has a configuration in which a magnetic rotator and a permanent magnet are sandwiched between upper and lower yokes. Ports of the magnetic rotator are connected to a terminal electrode while bypassing the lower yoke. JP 2002-043808A discloses a composite part obtained by integrating an insulating resin having a terminal electrode and a lower yoke. However, the composite part disclosed in JP 2002-043808A needs to be produced by an insert molding method, so that manufacturing cost is high, and reliability is not enough.

On the other hand, a non-reciprocal circuit element described in JP 2015-050689A has a structure in which a printed board mounting a magnetic rotator is sandwiched between upper and lower yokes. A part of the lower surface of the printed board is made to be exposed from the lower yoke, and a terminal electrode is formed on the exposed portion of the printed board. This makes it possible to connect the magnetic rotator and the terminal electrode without using a composite part which is required to be produced by an insert molding method.

However, the non-reciprocal circuit element described in JP 2015-050689A needs to mount a plurality of chip type matching capacitors on the printed board, increasing the number of components.

### SUMMARY

One of the objectives of the present disclosure is to provide a non-reciprocal circuit element that does not require a composite part which is required to be produced by an insert molding method and has a reduced number of components and a communication apparatus having such a non-reciprocal circuit element.

A non-reciprocal circuit element according to the present disclosure includes a dielectric substrate having upper and lower surfaces, a magnetic rotator mounted on the dielectric substrate, and a permanent magnet that applies a magnetic field to the magnetic rotator. The dielectric substrate has a connection pattern formed on the upper surface thereof and connected to the magnetic rotator, a terminal electrode formed on the lower surface thereof and connected to the connection pattern, and a capacitor pattern formed on the upper surface, lower surface or inside the dielectric substrate.

A communication apparatus according to the present disclosure includes the above-described non-reciprocal circuit element.

As described above, according to the present disclosure, there can be provided a non-reciprocal circuit element that does not require a composite part which is required to be produced by an insert molding method and has a reduced number of components and a communication apparatus having such a non-reciprocal circuit element.

### BRIEF DESCRIPTION OF THE DRAWINGS

The above features and advantages of the present disclosure will be more apparent from the following description of certain embodiments taken in conjunction with the accompanying drawings, in which:
FIG. 1 is a schematic perspective view from the upper side illustrating the outer appearance of a non-reciprocal circuit element 1 according to a first embodiment of the present disclosure;
FIG. 2 is a schematic perspective view from the lower side illustrating the outer appearance of the non-reciprocal circuit element 1;
FIG. 3 is a schematic perspective view illustrating a state where the lower yoke 40 is removed from the non-reciprocal circuit element 1;
FIG. 4 is a schematic perspective view illustrating a state where the permanent magnet 20 and upper yoke 30 are removed from the non-reciprocal circuit element 1;
FIG. 5 is a schematic perspective view of the dielectric substrate 10;
FIG. 6 is a schematic plan view for explaining the structure of the magnetic rotator M;
FIG. 7 is a schematic perspective view illustrating a state where the center conductor 81 is removed from the magnetic rotator M;
FIG. 8 is a schematic perspective view from the upper side illustrating the outer appearance of a non-reciprocal circuit element 2 according to a second embodiment of the present disclosure;
FIG. 9 is a schematic perspective view from the lower side illustrating the outer appearance of the non-reciprocal circuit element 2;
FIG. 10 is a schematic perspective view illustrating a state where the permanent magnet 20 and upper yoke 30 are removed from the non-reciprocal circuit element 2;
FIG. 11 is a schematic perspective view illustrating a state where the permanent magnet 20, upper yoke 30, and magnetic rotator M are removed from the non-reciprocal circuit element 2;
FIG. 12 is a schematic perspective view of the dielectric substrate 100;
FIG. 13 is a schematic perspective view from the upper side illustrating the outer appearance of a non-reciprocal circuit element 3 according to a third embodiment of the present disclosure;
FIG. 14 is a schematic perspective view from the lower side illustrating the outer appearance of the non-reciprocal circuit element 3;
FIG. 15 is a schematic perspective view illustrating a state where the permanent magnet 20 and upper yoke 30 are removed from the non-reciprocal circuit element 3;
FIG. 16 is a schematic perspective view illustrating a state where the permanent magnet 20, upper yoke 30, and magnetic rotator M are removed from the non-reciprocal circuit element 3;
FIG. 17 is a schematic perspective view of the dielectric substrate 110; and
FIG. 18 is a block diagram illustrating the configuration of a communication apparatus 200 using the non-reciprocal circuit element according to the above embodiments.

### DETAILED DESCRIPTION OF THE EMBODIMENTS

Some embodiments of the present disclosure will be explained below in detail with reference to the accompanying drawings.

### <First Embodiment>

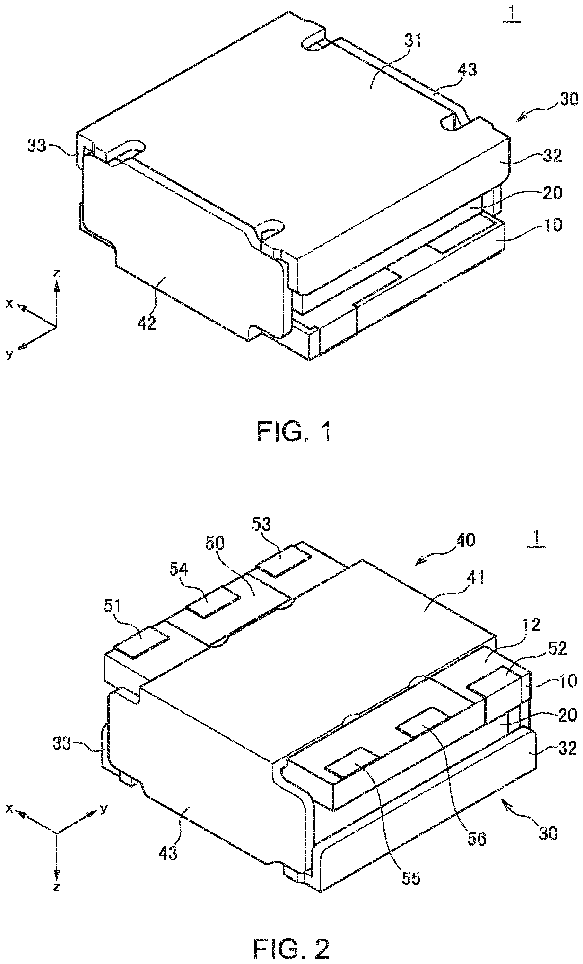

FIGS. 1 and 2 are schematic perspective views illustrating the outer appearance of a non-reciprocal circuit element 1 according to a first embodiment of the present disclosure. FIG. 1 is a view from the upper side, and FIG. 2 is a view from the lower side.

The non-reciprocal circuit element 1 according to the present embodiment is a non-reciprocal circuit element of a surface mount type and includes, as illustrated in FIGS. 1 and 2, a dielectric substrate 10, a permanent magnet 20, an upper yoke 30, and a lower yoke 40. The dielectric substrate 10 and permanent magnet 20 are sandwiched between the upper and lower yokes 30 and 40. The dielectric substrate 10 has, on its lower surface 12, terminal electrodes 51 to 56 and a ground pattern 50. The upper yoke 30 has a top plate part 31 constituting the xy plane and folding parts 32 and 33 constituting the yz plane. The lower yoke 40 has a bottom plate part 41 constituting the xy plane and folding parts 42 and 43 constituting the xz plane. The folding parts 42 and 43 of the lower yoke 40 are fitted to the top plate part 31 of the upper yoke 30 to constitute a closed magnetic path.

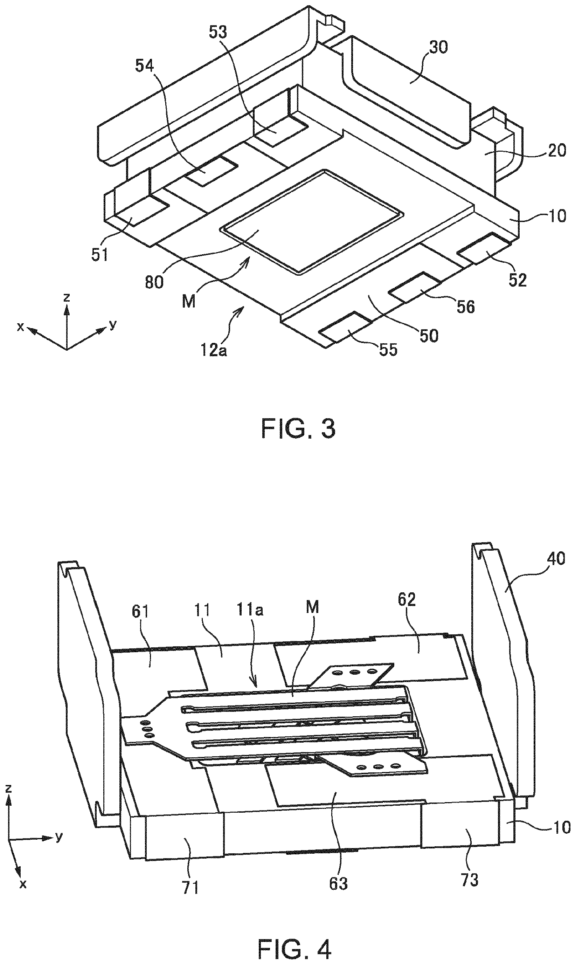

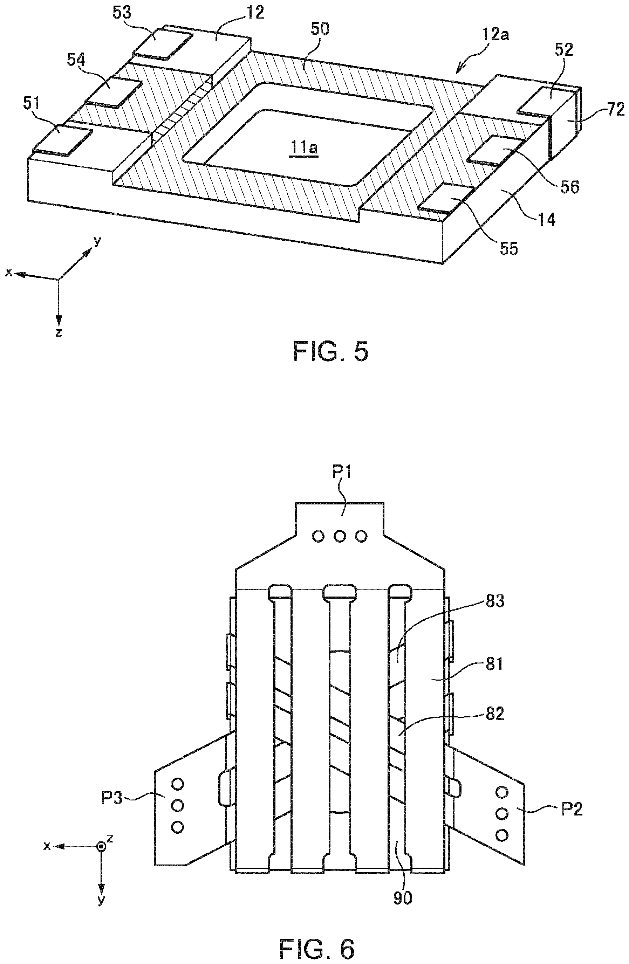

FIG. 3 is a schematic perspective view illustrating a state where the lower yoke 40 is removed from the non-reciprocal circuit element 1. FIG. 4 is a schematic perspective view illustrating a state where the permanent magnet 20 and upper yoke 30 are removed from the non-reciprocal circuit element 1. FIG. 5 is a schematic perspective view of the dielectric substrate 10.

As illustrated in FIGS. 3 to 5, the dielectric substrate 10 has upper and lower surfaces 11 and 12 constituting the xy plane, and a through hole 11a penetrates substantially the center portion of the dielectric substrate 10 in the z-direction. A magnetic rotator M is accommodated in the through hole 11a. An upper surface 11 of the dielectric substrate 10 is flat, while a lower surface 12 of the dielectric substrate 10 has a recessed part 12a extending in the y-direction, where the thickness of the dielectric substrate 10 is reduced. The bottom plate part 41 of the lower yoke 40 is accommodated in the recessed part 12a. This prevents the bottom plate part 41 of the lower yoke 40 from protruding from the lower surface 12 of the dielectric substrate 10.

Connection patterns 61 to 63 are provided on the upper surface 11 of the dielectric substrate 10. The connection patterns 61 to 63 are connected respectively to ports P1 to P3 of the magnetic rotator M. A part of each of the connection patterns 61 to 63 that overlaps the ground pattern 50 provided on the lower surface 12 serves also as a capacitance electrode of a capacitor. That is, the connection patterns 61 to 63 formed on the upper surface 11 of the dielectric substrate 10 and ground pattern 50 formed on the lower surface 12 of the dielectric substrate 10 constitute a capacitor pattern. The connection pattern 61 is connected to the terminal electrode 51 provided on the lower surface 12 of the dielectric substrate 10 through a connection pattern 71 provided on a side surface 13 of the dielectric substrate 10. The connection pattern 62 is connected to the terminal electrode 52 provided on the lower surface 12 of the dielectric substrate 10 through a connection pattern 72 provided on a side surface 14 of the dielectric substrate 10. The connection pattern 63 is connected to the terminal electrode 53 provided on the lower surface 12 of the dielectric substrate 10 through a connection pattern 73 provided on the side surface 13 of the dielectric substrate 10. The side surfaces 13 and 14 constitute the yz plane. The terminal electrodes 54 to 56 are connected to a ground conductor 80 included in the magnetic rotator M through the ground pattern 50 and the bottom plate part 41 of the lower yoke 40.

FIG. 6 is a schematic plan view for explaining the structure of the magnetic rotator M.

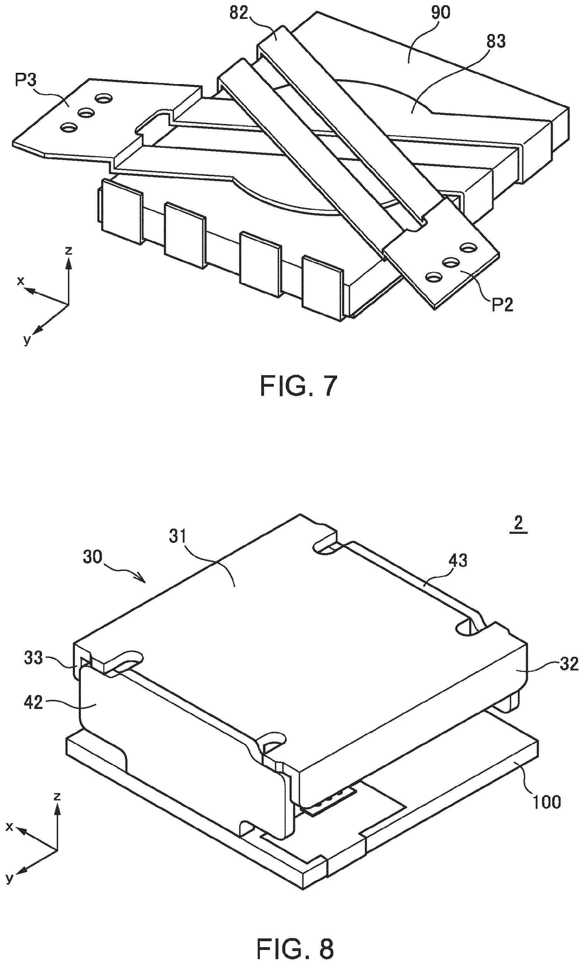

As illustrated in FIG. 6, the magnetic rotator M has center conductors 81 to 83 and a ferrite core 90. The center conductors 81 to 83 are each covered with an insulating film (which is omitted for easy understanding of the structure). FIG. 7 illustrates a state where the center conductor 81 is removed from the magnetic rotator M. The center conductors 81 to 83 are constituted by a plurality of metal conductors crossing one another at an angle of substantially 120°. In the example illustrated in FIGS. 6 and 7, the center conductor 81 is constituted by four metal conductors, and the center conductors 82 and 83 are each constituted by two metal conductors. The width of the center conductor 83 is enlarged at its center portion for characteristic adjustment, while the width of each of the center conductors 81 and 82 is constant. One ends of the center conductors 81 to 83 are connected respectively to the ports P1 to P3, and the other ends thereof are connected in common to the ground conductor 80 positioned on the back surface side of the ferrite core 90. As a result, the ferrite core 90 is sandwiched between the center conductors 81 to 83 and the ground conductor 80.

With the above configuration, the center conductor 81 is connected to the terminal electrode 51 through the connection patterns 61 and 71, the center conductor 82 is connected to the terminal electrode 52 through the connection patterns 62 and 72, and the center conductor 83 is connected to the terminal electrode 53 through the connection patterns 63 and 73. Further, the ground conductor 80 is connected to the terminal electrodes 54 to 56 through the bottom plate part 41 of the lower yoke 40 and the ground pattern 50.

As described above, a part of each of the connection patterns 61 to 63 provided on the upper surface 11 overlaps the ground pattern 50 provided on the lower surface 12 in the z-direction. A capacitance component obtained by the overlap between the connection patterns 61 to 63 and the ground pattern 50 is utilized as a matching capacitance. This eliminates the need to mount a chip type matching capacitor on the dielectric substrate 10, thus making it possible to reduce the number of components. The matching capacitance can be adjusted by the shape or area of each of the connection patterns 61 to 63. Further, the dielectric substrate 10 and lower yoke 40 are separated members, so that it is not necessary to use a composite part which is required to be produced by an insert molding method.

In addition, in the present embodiment, the through hole 11a is formed in the dielectric substrate 10, and the magnetic rotator M is accommodated in the through hole 11a, thus making it possible to reduce the height of the non-reciprocal circuit element 1. However, it is not essential to form the through hole 11a in the dielectric substrate 10. For example, instead of the through hole 11a, a groove part that does not penetrate the dielectric substrate 10 may be formed in the upper surface 11, in which a part of or the entire magnetic rotator M may be accommodated.

### <Second Embodiment>

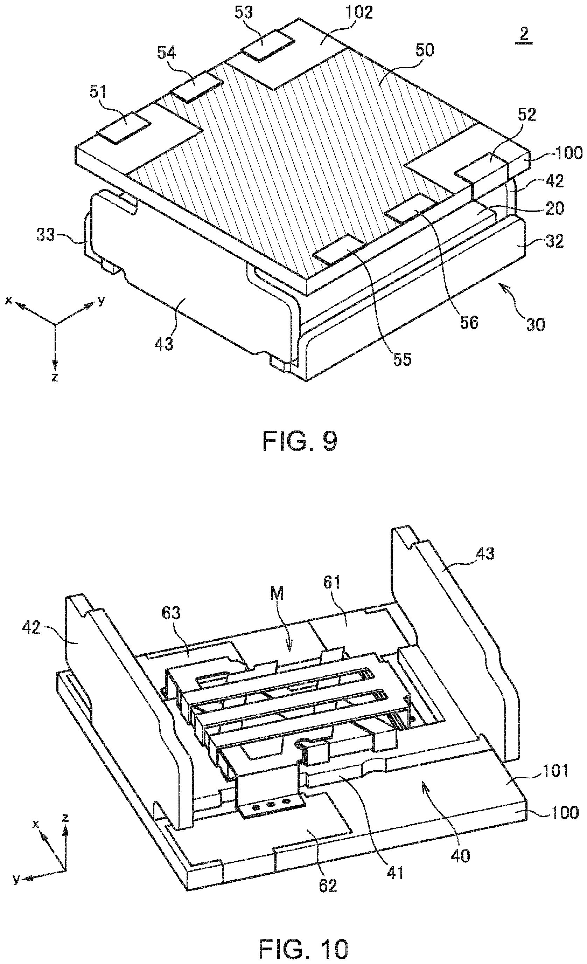

FIGS. 8 and 9 are schematic perspective views each illustrating the outer appearance of a non-reciprocal circuit element 2 according to a second embodiment of the present disclosure. FIG. 8 is a view from the upper side, and FIG. 9 is a view from the lower side.

As illustrated in FIGS. 8 and 9, the non-reciprocal circuit element 2 according to the second embodiment differs from the non-reciprocal circuit element 1 according to the first embodiment in that it uses a dielectric substrate 100 and that the bottom plate part 41 of the lower yoke 40 is fixed to an upper surface 101 side of the dielectric substrate 100. Other configurations are the same as those of the non-reciprocal circuit element 1 according to the first embodiment, so the same reference numerals are given to the same elements, and overlapping description will be omitted. Unlike the dielectric substrate 10 according to the first embodiment, the dielectric substrate 100 used in the present embodiment does not have the through hole and recessed part but has a simple plate-like structure.

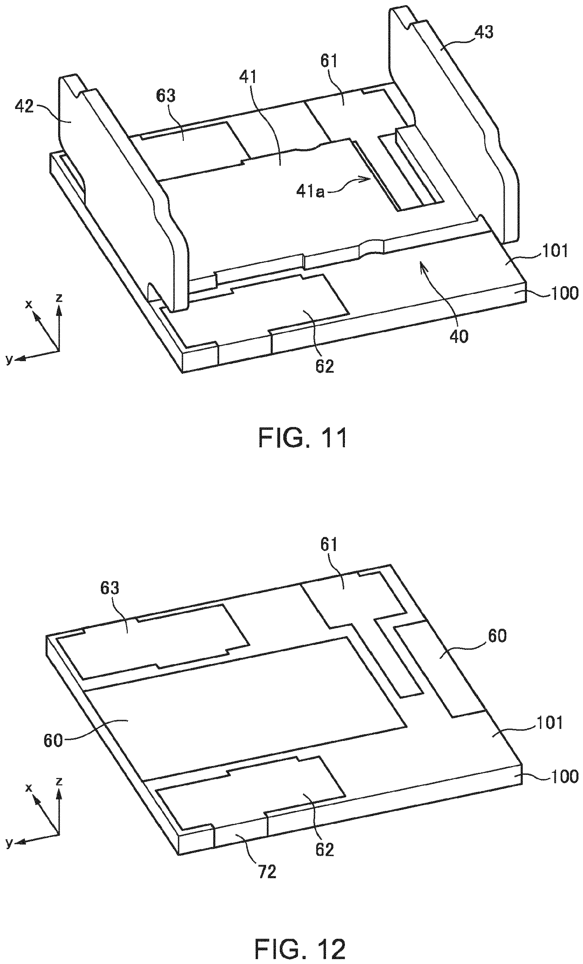

FIG. 10 is a schematic perspective view illustrating a state where the permanent magnet 20 and upper yoke 30 are removed from the non-reciprocal circuit element 2. FIG. 11 is a schematic perspective view illustrating a state where the permanent magnet 20, upper yoke 30, and magnetic rotator M are removed from the non-reciprocal circuit element 2. FIG. 12 is a schematic perspective view of the dielectric substrate 100.

As illustrated in FIGS. 10 to 12, connection patterns 60 to 63 are provided on the upper surface 101 of the dielectric substrate 100. The lower yoke 40 is fixed to the upper surface 101 of the dielectric substrate 100 such that the connection pattern 60 and the bottom plate part 41 contact each other. Further, the magnetic rotator M is disposed on the bottom plate part 41 of the lower yoke 40. The ports P1 to P3 of the magnetic rotator M are connected respectively to the connection patterns 61 to 63. The ground conductor 80 of the magnetic rotator M is connected to the bottom plate part 41 of the lower yoke 40. The bottom plate part 41 of the lower yoke 40 has a cutout part 41a for preventing interference with the connection pattern 61 and the port P1.

The connection pattern 60 is connected to the ground pattern 50 provided on a lower surface 102 of the dielectric substrate 100 through a via conductor penetrating the dielectric substrate 100 or a connection pattern provided on the side surface of the dielectric substrate 100. A part of each of the connection patterns 61 to 63 provided on the upper surface 101 of the dielectric substrate 100 overlaps the ground pattern 50 provided on the lower surface 102 in the z-direction. A capacitance component obtained by the overlap between the connection patterns 61 to 63 and the ground pattern 50 is utilized as a matching capacitance.

As described above, in the non-reciprocal circuit element 2 according to the present embodiment, the dielectric substrate 100 has a simple plate-like structure, making it possible to reduce the manufacturing cost of the dielectric substrate 100. In addition, the dielectric substrate 100 exists outside a magnetic path formed by the upper and lower yokes 30 and 40, allowing a stronger magnetic field to be applied to the ferrite core 90.

### <Third Embodiment>

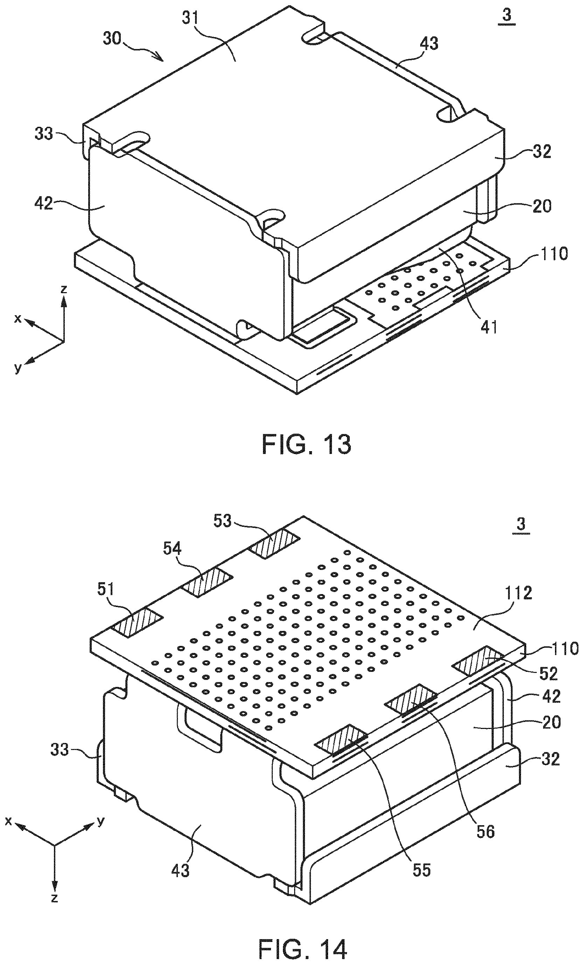

FIGS. 13 and 14 are schematic perspective views each illustrating the outer appearance of a non-reciprocal circuit element 3 according to a third embodiment of the present disclosure. FIG. 13 is a view from the upper side, and FIG. 14 is a view from the lower side.

As illustrated in FIGS. 13 and 14, the non-reciprocal circuit element 3 according to the third embodiment differs from the non-reciprocal circuit element 2 according to the second embodiment in that it uses a dielectric substrate 110. Other configurations are the same as those of the non-reciprocal circuit element 2 according to the second embodiment, so the same reference numerals are given to the same elements, and overlapping description will be omitted. The dielectric substrate 110 used in the present embodiment is an LTCC substrate having a multilayer structure and has, inside thereof, a not-shown capacitor pattern.

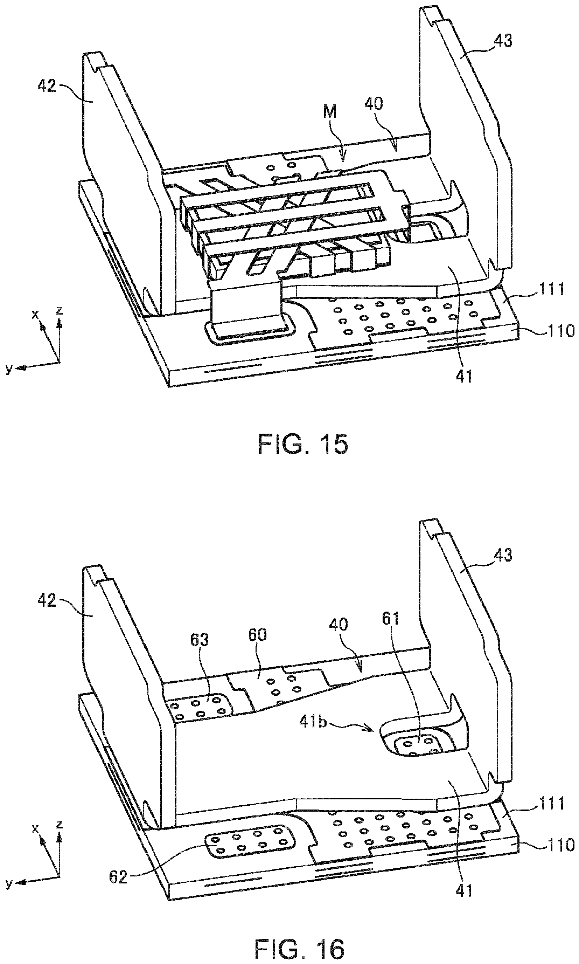

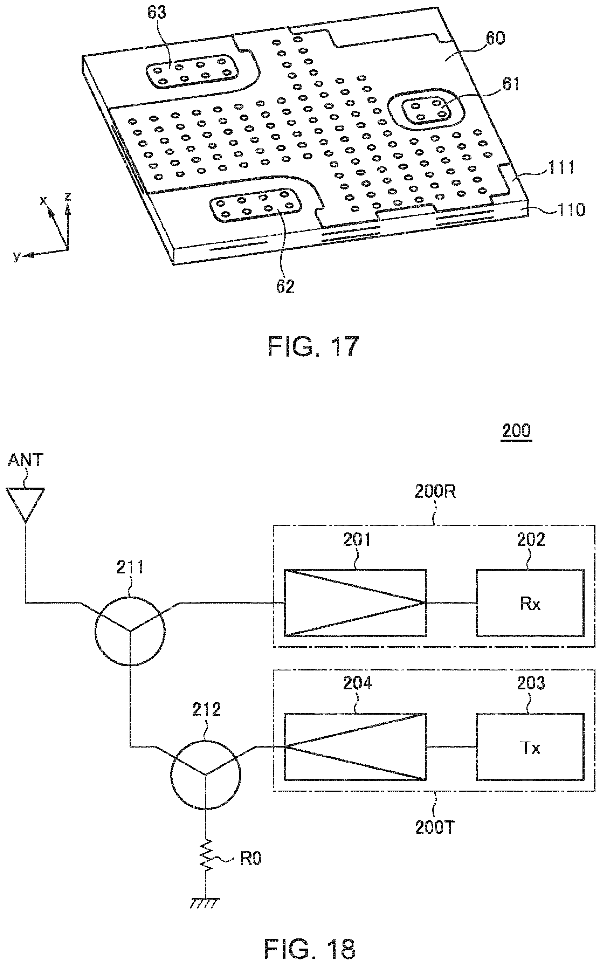

FIG. 15 is a schematic perspective view illustrating a state where the permanent magnet 20 and upper yoke 30 are removed from the non-reciprocal circuit element 3. FIG. 16 is a schematic perspective view illustrating a state where the permanent magnet 20, upper yoke 30, and magnetic rotator M are removed from the non-reciprocal circuit element 3. FIG. 17 is a schematic perspective view of the dielectric substrate 110.

As illustrated in FIGS. 15 to 17, connection patterns 60 to 63 are provided on an upper surface 111 of the dielectric substrate 110. The lower yoke 40 is fixed to the upper surface 111 of the dielectric substrate 110 such that the connection pattern 60 and the bottom plate part 41 contact each other. Further, the magnetic rotator M is disposed on the bottom plate part 41 of the lower yoke 40. The ports P1 to P3 of the magnetic rotator M are connected respectively to the connection patterns 61 to 63. The ground conductor 80 of the magnetic rotator M is connected to the bottom plate part 41 of the lower yoke 40. The bottom plate part 41 of the lower yoke 40 has a cutout part 41b for preventing interference with the connection pattern 61 and the port P1.

The connection patterns 61 to 63 are connected respectively to the terminal electrodes 51 to 53 provided on a lower surface 112 of the dielectric substrate 110 and to a not-shown capacitor pattern provided inside the dielectric substrate 110. The connection pattern 60 is connected to the terminal electrodes 54 to 56 and to another not-shown capacitor pattern provided inside the dielectric substrate 110. The capacitor pattern connected to the connection patterns 61 to 63 and the capacitor pattern connected to the connection pattern 60 are laid out so as to overlap each other with an LTCC material interposed therebetween. A capacitance component thus obtained by the overlap between the capacitor patterns is utilized as a matching capacitance.

As described above, the non-reciprocal circuit element 3 according to the present embodiment uses an LTCC substrate as the dielectric substrate 110, thereby facilitating adjustment of the matching capacitance upon design change.

### <Fourth Embodiment>

FIG. 18 is a block diagram illustrating the configuration of a communication apparatus 200 using the non-reciprocal circuit element according to the above embodiments.

A communication apparatus 200 illustrated in FIG. 18 is provided in, for example, a base station of a mobile communication system. The communication apparatus 200 incudes a receiving circuit part 200R and a transmitting circuit part 200T which are connected to an antenna ANT adapted for data transmission and reception. The receiving circuit part 200R includes a reception amplification circuit 201 and a receiving circuit 202 for processing a received signal. The transmitting circuit part 200T includes a transmitting circuit 203 for generating an audio signal and a video signal and a power amplification circuit 204.

In the thus configured communication apparatus 200, non-reciprocal circuit elements 211 and 212 are inserted respectively into a path between the antenna ANT and the receiving circuit part 200R and a path between the transmitting circuit part 200T and the antenna ANT. The non-reciprocal circuit elements 211 and 212 may each be the non-reciprocal circuit element 1, 2, or 3 according to the above embodiment. In the example illustrated in FIG. 18, the non-reciprocal circuit element 211 functions as a circulator, and the non-reciprocal circuit element 212 functions as an isolator having a terminal resistor R0.

While the one embodiment of the present disclosure has been described, the present disclosure is not limited to the above embodiment, and various modifications may be made within the scope of the present disclosure, and all such modifications are included in the present disclosure.

The technology according to the present disclosure includes the following configuration examples but not limited thereto.

A non-reciprocal circuit element according to the present disclosure includes a dielectric substrate having upper and lower surfaces, a magnetic rotator mounted on the dielectric substrate, and a permanent magnet that applies a magnetic field to the magnetic rotator. The dielectric substrate has a connection pattern formed on the upper surface thereof and connected to the magnetic rotator, a terminal electrode formed on the lower surface thereof and connected to the connection pattern, and a capacitor pattern formed on the upper surface, lower surface or inside the dielectric substrate.

A communication apparatus according to the present disclosure includes the above-described non-reciprocal circuit element.

According to the present disclosure, the terminal electrode is formed on the lower surface of the dielectric substrate mounting the magnetic rotator, so that the lower surface of the dielectric substrate can be used as a mounting surface. This eliminates the need to use a composite part which is required to be produced by an insert molding method. Further, a capacitor pattern is provided in the dielectric substrate itself, eliminating the need to use a chip type matching capacitor, which makes it possible to reduce the number of components.

The non-reciprocal circuit element according to the present disclosure may further include upper and lower yokes sandwiching the dielectric substrate, magnetic rotator, and permanent magnet, and the lower surface of the dielectric substrate may have a recessed part accommodating a part of the lower yoke. This prevents interference between the lower yoke and a mounting substrate upon surface mounting.

In the present disclosure, the upper surface of the dielectric substrate may have a groove part accommodating at least a part of the magnetic rotator, and the groove part may be a through hole penetrating the dielectric substrate. This makes it possible to reduce the height of the non-reciprocal circuit element.

The non-reciprocal circuit element according to the present disclosure may further include upper and lower yokes sandwiching the magnetic rotator and the permanent magnet, and the lower yoke may be fixed to the upper surface of the dielectric substrate. This eliminates the need to form a recessed part or the like in the lower surface of the dielectric substrate, making it possible to reduce the manufacturing cost of the dielectric substrate.

In the present disclosure, the capacitor pattern may be formed on the upper and lower surfaces of the dielectric substrate. This allows the use of a dielectric substrate having a single layer structure. Alternatively, a configuration may be possible, in which the dielectric substrate has a multilayer structure, and the capacitor pattern is formed inside the dielectric substrate. This facilitates adjustment of a matching capacitance obtained from the capacitor pattern.

As described above, according to the present disclosure, there can be provided a non-reciprocal circuit element that does not require a composite part which is required to be produced by an insert molding method and has a reduced number of components and a communication apparatus having such a non-reciprocal circuit element.

## Claims

1. A non-reciprocal circuit element comprising:
a dielectric substrate having upper and lower surfaces;
a magnetic rotator mounted on the dielectric substrate; and
a permanent magnet that applies a magnetic field to the magnetic rotator,
wherein the dielectric substrate has a connection pattern formed on the upper surface thereof and connected to the magnetic rotator, a terminal electrode formed on the lower surface thereof and connected to the connection pattern, and a capacitor pattern formed on the upper surface, lower surface or inside the dielectric substrate.

2. The non-reciprocal circuit element as claimed in claim 1, further comprising upper and lower yokes sandwiching the dielectric substrate, magnetic rotator, and permanent magnet,
wherein the lower surface of the dielectric substrate has a recessed part accommodating a part of the lower yoke.

3. The non-reciprocal circuit element as claimed in claim 1 or 2, wherein the upper surface of the dielectric substrate has a groove part accommodating at least a part of the magnetic rotator.

4. The non-reciprocal circuit element as claimed in claim 3, wherein the groove part is a through hole penetrating the dielectric substrate.

5. The non-reciprocal circuit element as claimed in claim 1, further comprising upper and lower yokes sandwiching the magnetic rotator and the permanent magnet,
wherein the lower yoke is fixed to the upper surface of the dielectric substrate.

6. The non-reciprocal circuit element as claimed in any one of claims 1 to 5, wherein the capacitor pattern is formed on the upper and lower surfaces of the dielectric substrate.

7. The non-reciprocal circuit element as claimed in any one of claims 1 to 5,
wherein the dielectric substrate has a multilayer structure, and
wherein the capacitor pattern is formed inside the dielectric substrate.

8. A communication apparatus including the non-reciprocal circuit element as claimed in any one of claims 1 to 7.
